# EUROPEAN PATENT APPLICATION

(11) **EP 4 818 716 A1**
(43) Date of publication of application: **07.10.2026**
(21) Application number: 25855076.3
(22) Date of filing: 18.08.2025
(51) Int. Cl.: G01R 31/367, G01R 31/396, G01R 31/36, G01R 31/385, G01R 31/392, G06N 3/08, B60L 58/16

(54) **SOH ESTIMATION APPARATUS AND SOH ESTIMATION METHOD**

(30) Priority: 16.08.2024 KR 20240109996
(71) Applicant: LG Energy Solution, Ltd., Seoul 07335 (KR)
(72) Inventor: EOM, Jin-Uk, Daejeon 34122 (KR)
(74) Representative: Plasseraud IP
(86) International application number: PCT/KR2025/012490
(87) International publication number: WO 2026/038927

(57) **Abstract**

A SOH estimation apparatus according to an embodiment of the present disclosure includes a data obtaining unit configured to obtain battery data including voltage information and charging environment information of a target battery collected during a progress period of a charging event; and a data processing unit configured to estimate a first charge capacity associated with a current life state of the target battery based on the battery data using a first model, estimate a second charge capacity associated with an initial life state of the target battery based on the battery data using a second model, and estimate a SOH of the battery based on the first charge capacity and the second charge capacity.

## Description

### TECHNICAL FIELD

The present disclosure relates to a SOH estimation apparatus and method, and more specifically, to a SOH estimation apparatus and method of a battery based on voltage information and charging environment information obtained in an actual use environment.

This application is based on and claims priority from Korean Patent Application No. 10-2024-0109996, filed on August 16, 2024, with the Korean Intellectual Property Office, the disclosure of which is incorporated herein in its entirety by reference.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-discharging rate and high energy density.

A State of Health (SOH) of the battery is an indicator representing how much a current health state and performance have deteriorated compared to its initial state (BOL, Beginning of Life). Accurately determining a SOH of the battery is crucial for maintaining the battery, determining the replacement point, and ensuring performance and safety. In other words, accurate SOH estimation provides users with battery reliability and enables cost-effective operation.

Conventionally, the State of Charge (SOC) was primarily used to estimate the SOH of a battery. However, due to the inaccuracy of SOC measurements, SOH estimation could also be inaccurate. To address this issue, a method utilizing the OCV-SOC (Open Circuit Voltage - State of Charge) table, which represents the relationship between battery voltage and SOC, was introduced.

By using the OCV-SOC table, it is possible to calculate the SOC more accurately based on the battery voltage, and through this, the SOH may be estimated. However, this method has several problems in practical application. Since the OCV-SOC relationship of a battery may vary depending on the temperature and the degree of degradation, a plurality of OCV-SOC tables according to a plurality of temperature conditions and a plurality of degrees of degradation must be individually prepared in advance through preliminary experiments. This process is time-consuming and expensive, and it is practically difficult to estimate the SOH of a battery under various use environments.

Such problems reveal the need to improve the SOH estimation method of a battery, and the development of a more efficient and practical method is emerging as an important research topic.

### DISCLOSURE

### Technical Problem

The present disclosure is designed to solve the problems of the related art, and therefore the present disclosure is directed to providing a SOH estimation apparatus and method, which estimates the SOH of a battery more efficiently in various battery use environments.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A SOH estimation apparatus according to one aspect of the present disclosure may comprise a data obtaining unit configured to obtain battery data including voltage information and charging environment information of a target battery collected during a progress period of a charging event; and a data processing unit configured to estimate a first charge capacity associated with a current life state of the target battery based on the battery data using a first model, estimate a second charge capacity associated with an initial life state of the target battery based on the battery data using a second model, and estimate a SOH of the battery based on the first charge capacity and the second charge capacity.

Features of the second model may be voltage information and charging environment information.

The voltage information may include at least one of a charging start voltage and a charging end voltage.

The charging environment information may include at least one of a charging start temperature, a charging end temperature, a maximum current, a minimum current, and a charging end current.

A label of the second model may be a charge capacity.

The second model may be trained using a training data set that includes at least two of a plurality of charge history data sets individually associated with a plurality of reference batteries of the same type as the target battery.

The charge history data set may include voltage information, charging environment information, and charge capacity for each charging event completed for a reference battery.

The training data set may be extracted as a result of applying a predetermined filtering condition to the plurality of charge history data sets.

The filtering condition may be satisfied when a degradation influence factor value is less than or equal to a predetermined value or a cumulative cycle count is less than or equal to a predetermined value.

The data processing unit may estimate a ratio between the first charge capacity and the second charge capacity as the SOH of the battery.

A server according to another aspect of the present disclosure may comprise the SOH estimation apparatus.

A battery pack according to still another aspect of the present disclosure may comprise the SOH estimation apparatus.

A vehicle according to still another aspect of the present disclosure may comprise the SOH estimation apparatus.

A SOH estimation method according to still another aspect of the present disclosure may comprise: obtaining battery data including voltage information and charging environment information of a target battery collected during a progress period of a charging event; estimating a first charge capacity associated with a current life state of the target battery based on the battery data using a first model; estimating a second charge capacity associated with an initial life state of the target battery based on the battery data using a second model; and estimating a SOH of the battery based on the first charge capacity and the second charge capacity.

### Advantageous Effects

According to one aspect of the present disclosure, even if a plurality of OCV-SOC tables individually mapped to various charging conditions in which the battery may be placed are not prepared in advance, it is possible to estimate not only the charge capacity associated with the current life state of the battery but also the charge capacity associated with the initial life state that has already passed based on battery data collected in an actual use environment in which a charging event of the battery is taking place, so that the SOH of the battery may be estimated more efficiently in various use environments.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a SOH estimation apparatus according to an embodiment of the present disclosure.
FIG. 2 is a schematic diagram showing the structure of a deep neural network for machine learning.
FIG. 3 is a diagram used to illustrate the functions of a second model.
FIG. 4 is a diagram schematically showing the corresponding relationship between a driving distance of a vehicle and the estimated SOH.
FIG. 5 is a diagram schematically showing a server including the SOH estimation apparatus according to an embodiment of the present disclosure.
FIG. 6 is a diagram schematically showing an exemplary configuration of a battery pack including the SOH estimation apparatus according to an embodiment of the present disclosure.
FIG. 7 is a diagram schematically showing a vehicle according to still another embodiment of the present disclosure.
FIG. 8 is a diagram schematically showing a SOH estimation method according to still another embodiment of the present disclosure.
FIG. 9 is a diagram schematically showing a SOH estimation method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

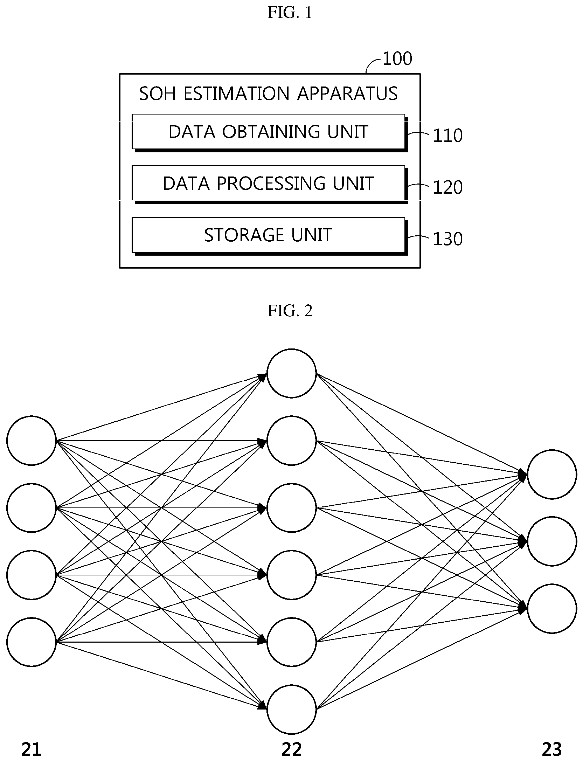

FIG. 1 is a diagram schematically showing a SOH estimation apparatus 100 according to an embodiment of the present disclosure.

Referring to FIG. 1, the SOH estimation apparatus 100 may include a data obtaining unit 110 and a data processing unit 120. The SOH estimation apparatus 100 may further include a storage unit 130.

The data obtaining unit 110 may obtain battery data including voltage information and charging environment information of a target battery collected during the progress period of a charging event.

That is, the data obtaining unit 110 may obtain battery data collected during the progress period of a charging event for the target battery, and the battery data may be used to estimate the SOH of the target battery.

Here, the battery refers to an independent cell that has a negative terminal and a positive terminal and is physically separable. As an example, a lithium-ion battery or a lithium polymer battery may be considered as a battery. Additionally, the type of battery may be a cylindrical type, a prismatic type, or a pouch type. Additionally, the battery may mean a battery bank, a battery module or a battery pack in which a plurality of cells are connected in series and/or parallel. Below, for convenience of explanation, the battery is explained as meaning one independent cell.

For example, the data obtaining unit 110 may generate battery data by directly measuring the voltage, current, and temperature of the target battery. Specifically, the data obtaining unit 110 may measure the positive electrode voltage and the negative electrode voltage through a pair of voltage sensing lines respectively connected to the positive electrode and the negative electrode of the target battery, and measure the voltage across both terminals of the target battery based on the voltage difference between the measured positive electrode voltage and the negative electrode voltage. The data obtaining unit 110 may measure the current of the target battery through a current measurement unit. For example, the current measurement unit may be a current sensor or a shunt resistor installed on a charge/discharge path of the battery and capable of measuring the current of the target battery. Here, the charge/discharge path of the battery may be a high current path through which a charge current is applied to the battery or a discharge current is output from the battery.

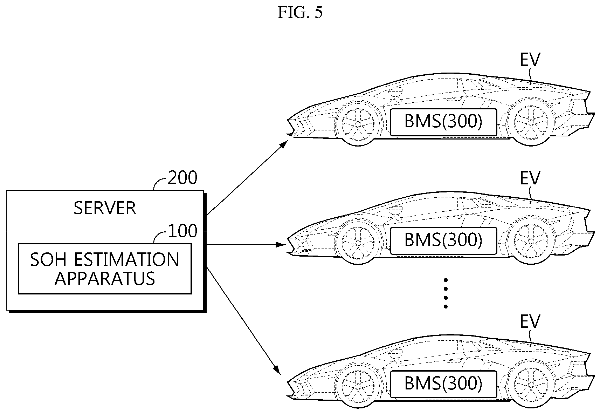

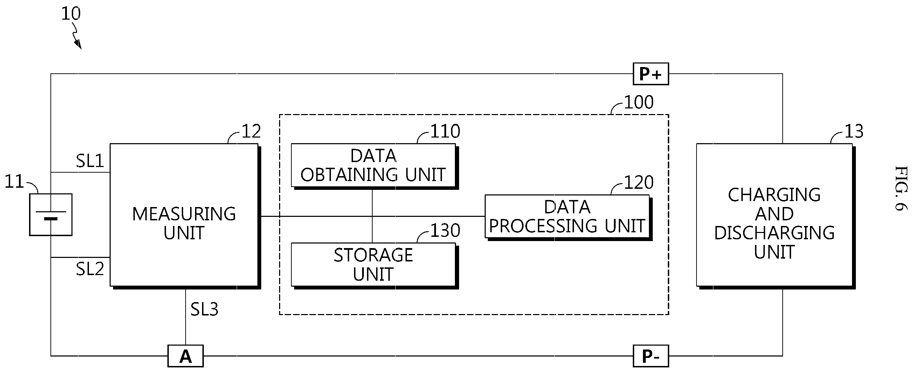

As another example, the data obtaining unit 110 may receive battery data from an external device. As shown in FIG. 6, when the SOH estimation apparatus 100 is mounted on a vehicle 1, the external devices may be a measuring unit 12 or a current measurement unit A. As shown in FIG. 5, when the SOH estimation apparatus 100 is mounted on a server 200, the external device may be a BMS 300 of each vehicle. The data obtaining unit 110 may receive battery data by being connected to an external device via a wired and/or wireless connection. For example, the data obtaining unit 110 may receive measurement information from the external device using CAN (Controller Area Network) communication or CAN-FD (CAN with Flexible Data rate) communication. As another example, the data obtaining unit 110 may receive measurement information from the external device using Zigbee, Bluetooth, WIFI, or a mobile communication network. Of course, as long as it supports communication between the data obtaining unit 110 and the outside, the type of communication protocol is not particularly limited.

As another example, the data obtaining unit 110 may include an input means (e.g., a keyboard, a touch panel, a microphone) for receiving battery data from a user, etc.

The target battery refers to a battery (see 11 in FIG. 6) to which the present disclosure applies. That is, the target battery is the subject of SOH estimation and the source of battery data collected during a charging event.

A charging event refers to the entire process by which a battery receives and stores electrical energy from an external power source. Specifically, a charging event includes the period from the time point that an external power source is connected to the battery and current begins to flow until the time point that the voltage reaches a certain level and charging is terminated.

The charging start time point is the time point at which battery charging begins. This is typically when the charger and the battery are connected and the charger executes a charging command. The charging end time point is the time point at which the battery is fully charged or charging stops for safety reasons. This is typically when the battery voltage reaches a maximum value or the set charging time has ended.

The charging event may provide important data for estimating the SOH of a battery. That is, data collected during the charging process may be used to estimate the SOH of a battery.

Voltage information is information indicating the voltage change history of the battery over the progress period of the charging event, and may include at least one of a charging start voltage and a charging end voltage.

The charging start voltage refers to the battery voltage when current starts to be supplied to the battery. Preferably, the charging start voltage may refer to the OCV (Open Circuit Voltage) at the charging start time point. The charging end voltage refers to the voltage of the battery when charging of the battery is completed. This indicates the final state that the battery has reached through a charging cycle. Preferably, the charging end voltage may refer to the OCV at the charging end time point. Since the OCV reflects the chemical balance state inside the battery, the OCV at the end of charging may more accurately evaluate the charge level of the battery.

Charging environment information is information indicating the temperature change history and the current change history of the battery over the progress period of the charging event, and may include at least one of a charging start temperature, a charging end temperature, a maximum current, a minimum current, and a charging end current.

Charging environment information includes several environmental factors monitored during battery charging.

Charging start temperature refers to the temperature at which a battery begins charging. Charging start temperature affects the chemical reaction and charging speed of the battery, which may directly affect charging efficiency and battery life.

Charging end temperature refers to the temperature at which a battery is fully charged. Charging end temperature is related to safety. This is because excessive temperature rise due to charging may lead to reduced battery performance and shortened lifespan. Furthermore, charging end temperature is related to battery performance and lifespan.

Maximum current means the maximum value of the charging current supplied to the battery during the charging event.

Minimum current refers to the lowest amount of current supplied to the battery during the charging event. Minimum current is primarily important in the initial or final stages of battery charging and directly affects the safety and lifespan of the battery.

Charging end current refers to the current when the battery is fully charged. Charging end current is related to charging efficiency and battery protection.

The data processing unit 120 may estimate the first charge capacity related to the current life state (MOL, Middle of Life) of the target battery based on battery data using the first model.

Specifically, the data processing unit 120 may estimate the first charge capacity, which represents the actual increase in the remaining capacity of the battery during the charging event, using the first model. The first charge capacity is closely related to the current life state of the target battery, and the data processing unit 120 may perform this estimation based on the battery data of the target battery. More specifically, the data processing unit 120 may calculate the increase in electrical energy stored in the battery from the start time point to the end time point of the charging event.

The first model may include various known methods for calculating the charge capacity of the battery. Specifically, it may include machine learning algorithms, statistical methods, or engineering approaches that analyze physical characteristics of the battery, such as voltage, current, and temperature. For example, methods such as ampere-hour counting, Coulomb counting, OCV-SOC curve, and Extended Kalman Filter (EKF) may be used. The first model may be designed considering the characteristics and charging pattern of the target battery.

The data processing unit 120 may estimate the second charge capacity associated with the initial life state (BOL) of the target battery based on the battery data using the second model.

The second charge capacity is closely related to the initial life state of the target battery, and the data processing unit 120 may perform this estimation based on the battery data of the target battery. That is, the data processing unit 120 may estimate the second charge capacity related to the initial life state based on the current battery data.

Specifically, the second charge capacity is an estimate of the amount of increase in the remaining capacity of the target battery that would have occurred if the charging event had occurred when the target battery was in its initial life state (BOL).

The second model may be a machine learning-based artificial intelligence model. The second model may analyze the battery data of the target battery to estimate the charge capacity in the BOL state.

FIG. 2 is a schematic diagram showing the structure of a deep neural network for machine learning.

Referring to FIG. 2, a deep neural network may be composed of an input layer 21, one or more hidden layers 22, and an output layer 23.

Machine learning is a technology that enables computers to learn from data, recognize patterns, and make decisions on their own. Specifically, a machine learning model is a mathematical model built to learn from data and perform specific tasks (e.g., prediction, classification, clustering). This model is trained through algorithms to identify and understand patterns and relationships in data, enabling it to make useful decisions about new data.

For example, the second model may be XGBOOST (eXtreme Gradient Boosting), LR (Logistic Regression), LASSO (Least Absolute Shrinkage and Selection operator), RIDGE, EN (Elastic Net), LAR (Least Angle Regression), LLAR (Lasso Least Angle Regression), OMP (Orthogonal Matching Pursuit), BR (Bayesian Ridge), ARD (Automatic Relevance Determination),PAR (Passive Aggressive Regressor), RANSAC (Random Sample Consensus), TR (TheilSen Regressor), HUBER, KR (Kernel Ridge), SVM (Support Vector Machine), KNN (K-Nearest Neighbor),DT (Decision Trees), RF (Random Forest), ET (Extra Tree), ADA (ADAboost), GBR (Gradient Boosting Regressor), MLP (Multi Layer Perceptron), LIGHTGBM (Light Gradient Boosting Model) or CATBOOST.

The second model may be a machine learning model trained with the optimal combination of hyperparameters by tuning the hyperparameters of the XGBoost model through Bayesian Optimization and K-Fold Cross-Validation.

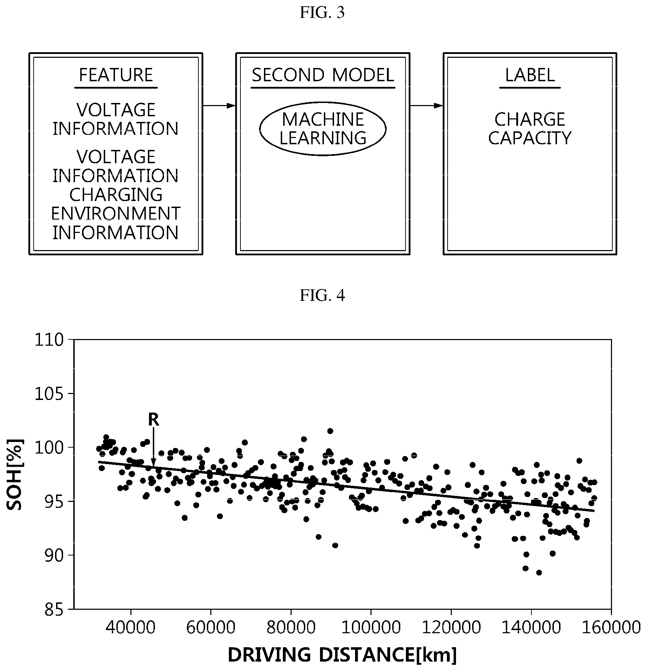

FIG. 3 is a diagram used to illustrate the functions of a second model.

Referring to FIG. 3 together with FIG. 2, the data processing unit 120 inputs at least one input variable included in voltage information and charging environment information into the input layer 21 of the second model, and may determine the second charge capacity, which is a value output from the output layer 23 of the second model as an estimation result for the charge capacity associated with the initial life state of the target battery.

The features of the second model may include voltage information and charging environment information. That is, at least one input variable extracted from battery data obtained during the battery charging process may be used as a feature of the second model.

The label of the second model may be the charge capacity. That is, the charge capacity may be the output variable of the second model.

The second model may be trained using data collected from a plurality of reference batteries of the same type as the target battery. The feature data is input into a machine learning algorithm and used to estimate the charge capacity.

The second model may be trained using a training data set including at least two of a plurality of charge history data sets individually associated with the plurality of reference batteries of the same type as the target battery.

That is, the charge history data set used for training the second model may be collected from each of the plurality of reference batteries of the same type as the target battery.

The charge history data set may include voltage information, charging environment information, and charge capacity for each charging event completed for the reference battery. That is, the charge history data set may include voltage information, charging environment information, and charge capacity for multiple charging events for each reference battery.

The charge history data set is collected under various charging conditions and environments, allowing the second model to learn various scenarios that may occur during a charging event. In other words, the charge history data reflects the performance of each battery under various charging cycles and environmental conditions.

The second model may improve the accuracy of estimation by learning using a training data set that includes at least two of a plurality of charge history data sets.

The data processing unit 120 may estimate the SOH of the battery based on the first charge capacity and the second charge capacity.

Specifically, the data processing unit 120 may estimate the ratio between the first charge capacity and the second charge capacity as the SOH of the battery.

The data processing unit 120 may calculate the ratio of the first charge capacity to the second charge capacity. This ratio represents an estimate of the ratio of the full charged capacity (FCC) of the battery in the initial life state to the full charged capacity in the current life state, which may be used to quantitatively evaluate the state of health of the battery.

For example, the SOH of the battery may be calculated using Formula 1. [Formula 1] $SOH \left(%\right) = \frac{First Charge Capacity}{Second Charge Capacity} \times 100$

For example, if the first charge capacity is 70% of the second charge capacity, the SOH of the battery is estimated to be 70%. This means that the battery maintains a performance equivalent to 70% of the capacity in the BOL state.

FIG. 4 is a diagram schematically showing the corresponding relationship between a driving distance of a vehicle and the estimated SOH.

In the embodiment of FIG. 4, the horizontal axis (X-axis) represents the driving distance (km), and the vertical axis (Y-axis) represents the SOH (%).

Specifically, FIG. 4 is an exemplary scatter plot showing the relationship between the driving distance of a vehicle equipped with the target battery and the SOH estimated by the SOH estimation apparatus 100.

Referring to FIG. 4, the overall trend of the data shows a gradual decrease in SOH as the driving distance increases. This indicates that as the driving distance of a vehicle increases, the life state of the target battery deteriorates.

The regression line R shown in FIG. 4 shows a negative linear relationship between the driving distance and the SOH. That is, since the slope of the regression line R is negative, it shows that SOH decreases as the driving distance increases.

Since the data points are generally distributed around the regression line R, it may be seen that the driving distance and the estimated SOH have a very close correlation, and specifically, this is a negative correlation.

The SOH estimation apparatus 100 according to an embodiment of the present disclosure may more efficiently estimate the SOH of a battery in various use environments. Specifically, the SOH estimation apparatus 100 utilizes machine learning to estimate two charge capacities individually associated with two different life states of a battery based on the battery data collected in an actual use environment (field) of the battery, thereby more efficiently estimating the SOH of a battery in various use environments.

Meanwhile, the data processing unit 120 included in the SOH estimation apparatus 100 optionally include a processor, an application-specific integrated circuit (ASIC), other chipset, a logic circuit, a register, a communication modem, a data processing device, etc. known in the art to execute various control logics performed in the present disclosure. Also, when the control logic is implemented as software, the data processing unit 120 may be implemented as a set of program modules. At this time, the program module may be stored in the memory and executed by the data processing unit 120. The memory may be inside or outside the data processing unit 120 and may be connected to the data processing unit 120 by various well-known means.

In addition, the SOH estimation apparatus 100 may further include a storage unit 130. The storage unit 130 may store data necessary for operation and function of each component of the SOH estimation apparatus 100, data generated in the process of performing the operation or function, or the like. The storage unit 130 is not particularly limited in its kind as long as it is a known information storage means that may record, erase, update and read data. As an example, the information storage means may include RAM, flash memory, ROM, EEPROM, registers, and the like. In addition, the storage unit 130 may store program codes in which processes executable by the data processing unit 120 are defined.

Specifically, the storage unit 130 may store information necessary for the data processing unit 120 to estimate the SOH of the battery. For example, the storage unit 130 may store the battery data of the target battery, the algorithm of the first model, the algorithm of the second model, etc. In addition, the data processing unit 120 may access the storage unit 130 to obtain information necessary for estimating the SOH of the battery.

The second model may be trained based on a training data set that has been preprocessed from a plurality of collected charge history data sets. For example, only the necessary charge history data may be extracted from the collected charge history data set as a training data set, and then the second model may be trained based on the extracted training data set.

The training data set may be extracted as a result of applying a predetermined filtering condition to a plurality of charge history data sets.

The filtering condition may be satisfied when the degradation influence factor value is less than or equal to a predetermined value or the cumulative cycle count is less than or equal to a predetermined value. By applying the filtering condition to all collected charge history data sets, only data related to the initial life state may be extracted from each charge history data set.

In machine learning, data preprocessing and filtering are essential steps for optimizing model performance. Improving data quality and format makes the learning process more efficient and removes unnecessary or erroneous data, thereby yielding more accurate results.

Specifically, one of the filtering conditions is to select only data with a degradation influence factor value less than or equal to a predetermined value. The degradation influence factor is an indicator (e.g., cumulative driving range) that reflects various factors (e.g., temperature, charging speed, overcharging, internal resistance, etc.) related to the lifespan of the battery. A higher value indicates a relatively greater battery degradation.

Another filtering condition is to select cases where the cumulative cycle count is less than or equal to a predetermined value. The cumulative cycle count represents the total number of times the battery has been charged and discharged, and a lower value indicates that the battery has been used relatively less. By using two or more charge history data sets that satisfy the aforementioned filtering conditions as the training data set of the second model, the second model may be trained using the charge history data collected during the period when each reference battery was in its initial life state.

Since the second model is trained using the training data set extracted as a result of applying the filtering conditions, the SOH estimation apparatus 100 may estimate the second charge capacity associated with the initial life state using the second model.

The data processing unit 120 may train the second model using the data collected from a plurality of reference batteries of the same type as the target battery.

Specifically, the data processing unit 120 may train the second model using a training data set including at least two of a plurality of charge history data sets individually associated with a plurality of reference batteries of the same type as the target battery. The charge history data set may include voltage information, charging environment information, and charge capacity for each charging event completed for the reference battery. That is, the charge history data set may include voltage information, charging environment information, and charge capacity for multiple charging events of each reference battery.

The data processing unit 120 may extract a training data set by applying a predetermined filtering condition to the plurality of charge history data sets.

The filtering condition may be satisfied when the degradation influence factor value is less than or equal to a predetermined value or the cumulative cycle count is less than or equal to a predetermined value. By applying the filtering condition to all collected charge history data sets, only data related to the initial life state may be extracted from each charge history data set.

The data processing unit 120 may continuously improve and update the second model using a recursive method. That is, data processing unit 120 may continuously collect new battery data and use it to recursively update the second model.

Specifically, the data processing unit 120 may repeatedly update and train the second model by using the information input to the second model, the charging environment information, and the second charge capacity estimated through the second model.

Through this process, the data processing unit 120 may continuously improve the estimation performance of the second model by continuously reflecting new data. In other words, because the data processing unit 120 may continuously update the second model using a recursive method, the accuracy of the second charge capacity estimation may be gradually improved.

The method for training the second model may be executed not only by the data processing unit 120, but also by a server, etc. That is, the second model may be trained and stored on the server (which may be a separate computing device other than the server illustrated in FIG. 5). The SOH estimation apparatus 100 may load the trained second model from the server to estimate the second charge capacity. For example, the SOH estimation apparatus 100 may download a model file from the server or receive the model through an API.

When the second model is trained on the server and the estimation using the second model is performed on the SOH estimation apparatus 100, there are advantages in securing efficiency and real-time performance. The server may utilize high-performance computing resources to quickly train large amounts of data and complex models, while the SOH estimation apparatus 100 is a lighter device capable of real-time estimation.

The SOH estimation apparatus 100 may set the usage conditions of the battery based on the estimated SOH result.

In one embodiment, the data processing unit 120 may be configured to compare the estimated SOH with a preset threshold value (e.g., SOH 80%) and control the usage conditions based on the comparison result.

For example, if the estimated SOH exceeds the threshold value, the data processing unit 120 may maintain the existing usage conditions. Conversely, if the estimated SOH is less than or equal to the threshold value, the data processing unit 120 may be configured to reduce the maximum charging and discharging rate. As another example, if the estimated SOH is less than or equal to the threshold value, the data processing unit 120 may be configured to reduce the charging end voltage. Here, the charging end voltage may refer to the maximum voltage allowed when charging the battery. As another example, if the estimated SOH is less than or equal to the threshold value, the data processing unit 120 may increase the discharging end voltage of the battery. Here, the discharging end voltage may refer to the minimum voltage allowed when discharging the battery.

In another embodiment, the data processing unit 120 may set the usage conditions according to a protocol preset to define a corresponding relationship between the SOH and the usage conditions.

For example, the protocol may be configured to specify the charging and discharging rate, the charging end voltage, and/or the discharging end voltage for each SOH period.

Therefore, the SOH estimation apparatus 100 may mitigate performance degradation of the battery and improve its lifespan and stability by appropriately controlling the usage conditions of the battery by considering the SOH estimation result.

FIG. 5 is a diagram schematically showing a server 200 including the SOH estimation apparatus 100 according to an embodiment of the present disclosure.

The SOH estimation apparatus 100 according to the present disclosure may be installed on a server 200. The server 200 provides high-performance computing resources and data storage capabilities to efficiently process complex machine learning models and algorithms. The SOH estimation apparatus 100 running on the server 200 may obtain battery data of a target battery, analyze it in real time, and continuously monitor the SOH of the battery. Specifically, the SOH estimation apparatus 100 running on server 200 may obtain battery data of a target battery and estimate the SOH of the battery based on the first charge capacity and the second charge capacity estimated using the first model and the second model.

The server 200 may be configured to communicate with the BMS (Battery Management System, 300) of vehicles EV equipped with the same type of battery. That is, the server 200 is connected to the BMS 300 of each vehicle EV via wires and/or wirelessly, and may exchange battery data, charge/discharge logs, and performance-related information for each charging event of the battery mounted on the vehicle EV in real time. The data transmitted from the BMS 300 includes information such as voltage, current, temperature, and cumulative cycle count, and such data may be used to estimate SOH. The server 200 may analyze the current state of the target battery based on the received data to estimate the SOH.

Referring to FIG. 5, when estimating the SOH of a battery mounted on one of the vehicles EVs, the battery of the vehicle EV corresponds to a 'target battery', and the battery of another vehicle EV corresponds to a 'reference battery'.

By utilizing the SOH estimation apparatus 100, which is equipped on the server 200 according to an embodiment of the present disclosure, multiple battery systems may be centrally managed and optimized efficiently. Furthermore, the calculations based on the server 200 enable advanced analysis and sophisticated modeling, significantly improving the accuracy and reliability of SOH estimation.

FIG. 6 is a diagram showing an exemplary configuration of the battery pack 10 including the SOH estimation apparatus 100 according to an embodiment of the present disclosure.

The SOH estimation apparatus 100 according to the present disclosure may be provided in the battery pack 10. That is, the battery pack 10 according to the present disclosure may include the above-described SOH estimation apparatus 100 and at least one battery cell. Additionally, the battery pack 10 may further include electrical components (relays, fuses, etc.) and a case.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the first sensing line SL1, the second sensing line SL2, and the third sensing line SL3. Specifically, the measuring unit 12 may be connected to the positive electrode terminal of the battery 11 through the first sensing line SL1, and to the negative electrode terminal of the battery 11 through the second sensing line SL2. The measuring unit 12 may measure the voltage of the battery 11 based on the voltage measured at each of the first sensing line SL1 and the second sensing line SL2.

In addition, the measuring unit 12 may be connected to a current measurement unit A through the third sensing line SL3. For example, the current measurement unit A may be an ammeter or shunt resistor that may measure the charging current and discharging current of the battery 11. The measuring unit 12 may calculate the charging amount by measuring the charging current of the battery 11 through the third sensing line SL3. Additionally, the measuring unit 12 may calculate the discharge amount by measuring the discharge current of the battery 11 through the third sensing line SL3.

The charging and discharging unit 13 may have one end connected to the positive electrode terminal P+ of the battery pack 10, and the other end connected to the negative electrode terminal P- of the battery pack 10. Accordingly, the positive electrode terminal of the battery 11, the positive electrode terminal P+ of the battery pack 10, the charging and discharging unit 13, the negative electrode terminal P- of the battery pack 10, and the negative electrode terminal of the battery 11 may be electrically connected.

In the present specification, the BMS 300 may include an SOH estimation apparatus 100, a measuring unit 12, and a current measurement unit A. In FIG. 6, the data obtaining unit 110 is depicted as having a distinct configuration from the measuring unit 12 and the current measurement unit A, but at least one of the measuring unit 12 and the current measurement unit A may be included in the data obtaining unit 110.

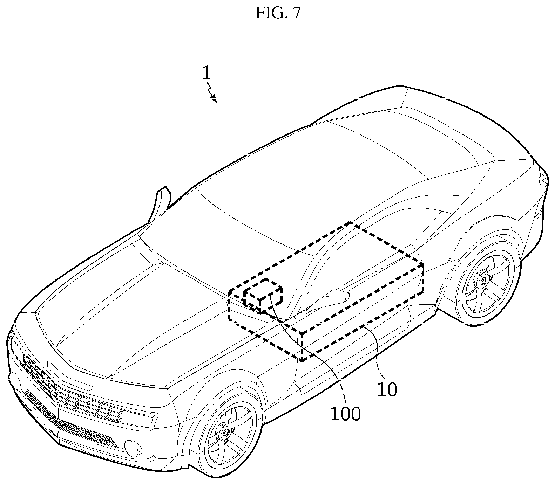

FIG. 7 is a diagram schematically showing a vehicle 1 according to still another embodiment of the present disclosure.

Referring to FIG. 7, the battery pack 10 described above with reference to FIG. 6 may be included in a vehicle 1 such as an electric vehicle (EV) or a hybrid vehicle (HV). In addition, the battery pack 10 may drive the vehicle 1 by supplying power to a motor through an inverter included in the vehicle 1. Here, the battery pack 10 may include the SOH estimation apparatus 100. In this case, the SOH estimation apparatus 100 may be an on-board device included in the vehicle 1.

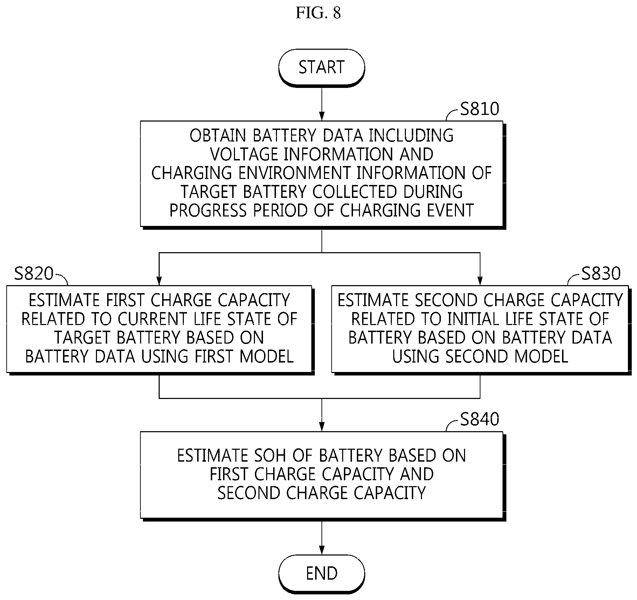

FIG. 8 is a diagram schematically showing a SOH estimation method according to still another embodiment of the present disclosure. Each step of the SOH estimation method may be performed by the SOH estimation apparatus 100. Hereinafter, for convenience of explanation, content that overlaps with the content described above will be omitted or briefly described.

Step S810 is a step of obtaining battery data including voltage information and charging environment information of a target battery collected during the progress period of a charging event, and may be performed by the data obtaining unit 110.

That is, the data obtaining unit 110 may obtain battery data collected during the progress period of a charging event for the target battery.

A charging event refers to the entire process in which a battery receives and stores electrical energy from an external power source.

The voltage information may include at least one of a charging start voltage and a charging end voltage.

The charging environment information may include at least one of a charging start temperature, a charging end temperature, a maximum current, a minimum current, and a charging end current.

Step S820 is a step of estimating the first charge capacity related to the current life state of the target battery based on the battery data using the first model, and may be performed by the data processing unit 120. Specifically, the data processing unit 120 may estimate the charge capacity of the battery increased during the charging event, i.e., the first charge capacity, using the first model.

Step S830 is a step of estimating the second charge capacity related to the initial life state of the battery based on the battery data using the second model, and may be performed by the data processing unit 120.

The data processing unit 120 may estimate the second charge capacity of a target battery using a second model based on machine learning. The second model may analyze the battery data of the target battery and estimate the charge capacity in the BOL state.

The features of the second model may be voltage information and charging environment information.

The label of the second model may be charge capacity.

The second model may be trained using a training data set including at least two of a plurality of charge history data sets individually associated with a plurality of reference batteries of the same type as the target battery.

The second model may be trained using charge history data sets collected from a plurality of reference batteries of the same type as the target battery. In other words, the charge history data sets used to train the second model may be collected from a plurality of reference batteries of the same type as the target battery.

The charge history data set may include voltage information, charging environment information, and charge capacity for each charging event completed for the reference battery. That is, the charge history data set may include voltage information, charging environment information, and charge capacity for multiple charging events for each reference battery.

Step S840 is a step of estimating the SOH of the battery based on the first charge capacity and the second charge capacity, and may be performed by the data processing unit 120.

Specifically, the data processing unit 120 may estimate the ratio between the first charge capacity and the second charge capacity as the SOH of the battery.

For example, the data processing unit 120 may estimate the SOH of a battery using Formula 1 described above.

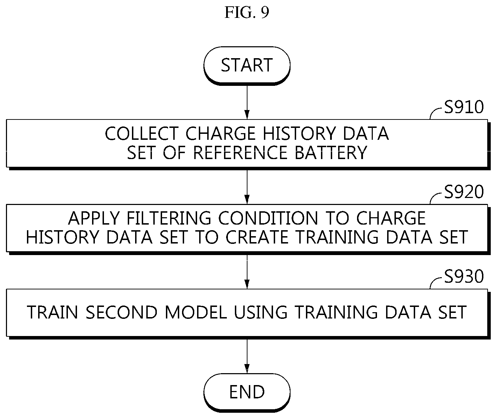

FIG. 9 is a diagram schematically showing a SOH estimation method according to still another embodiment of the present disclosure. Referring to FIG. 9, an embodiment of training the second model in the SOH estimation apparatus 100 is described. In the following, for convenience of explanation, any content that overlaps with the previously described content is omitted or briefly explained.

Step S910 is a step of collecting charge history data of a reference battery, and may be performed by the data processing unit 120.

The charge history data set may be collected from each of multiple reference batteries of the same type as the target battery.

The charge history data set may include voltage information, charging environment information, and charge capacity for each charging event completed for the reference battery. That is, the charge history data set may include voltage information, charging environment information, and charge capacity for multiple charging events for each reference battery.

Step S920 is a step of applying a filtering condition to a charge history data set to create a training data set, and may be performed by the data processing unit 120.

The filtering condition may be satisfied when the degradation influence factor value is less than or equal to a predetermined value or the cumulative cycle count is less than or equal to a predetermined value. By applying the filtering condition to all collected charge history data sets, only data related to the initial life state may be extracted from each charge history data set.

Step S930 is a step of training a second model using a training data set, and may be performed by the data processing unit 120.

The data processing unit 120 may continuously improve and update the second model using a recursive method. That is, the data processing unit 120 may continuously collect new battery data and use it to recursively update the second model.

Specifically, the data processing unit 120 may repeatedly update and train the second model by using the information input to the second model, the charging environment information, and the second charge capacity estimated through the second model.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

1: vehicle
10: battery pack
100: SOH estimation apparatus
110: data obtaining unit
120: data processing unit
130: storage unit
200: server
300: BMS

## Claims

1. A SOH estimation apparatus, comprising:
a data obtaining unit configured to obtain battery data including voltage information and charging environment information of a target battery collected during a progress period of a charging event; and
a data processing unit configured to estimate a first charge capacity associated with a current life state of the target battery based on the battery data using a first model, estimate a second charge capacity associated with an initial life state of the target battery based on the battery data using a second model, and estimate a SOH of the battery based on the first charge capacity and the second charge capacity.

2. The SOH estimation apparatus according to claim 1,
wherein features of the second model are voltage information and charging environment information,
wherein the voltage information includes at least one of a charging start voltage and a charging end voltage,
wherein the charging environment information includes at least one of a charging start temperature, a charging end temperature, a maximum current, a minimum current, and a charging end current, and
wherein a label of the second model is a charge capacity.

3. The SOH estimation apparatus according to claim 1,
wherein the second model is trained using a training data set that includes at least two of a plurality of charge history data sets individually associated with a plurality of reference batteries of the same type as the target battery, and
wherein the charge history data set includes voltage information, charging environment information, and charge capacity for each charging event completed for a reference battery.

4. The SOH estimation apparatus according to claim 3,
wherein the training data set is extracted as a result of applying a predetermined filtering condition to the plurality of charge history data sets.

5. The SOH estimation apparatus according to claim 4,
wherein the filtering condition is satisfied when a degradation influence factor value is less than or equal to a predetermined value or a cumulative cycle count is less than or equal to a predetermined value.

6. The SOH estimation apparatus according to claim 1,
wherein the data processing unit estimates a ratio between the first charge capacity and the second charge capacity as the SOH of the battery.

7. A server, comprising the SOH estimation apparatus according to any one of claims 1 to 6.

8. A battery pack, comprising the SOH estimation apparatus according to any one of claims 1 to 6.

9. A vehicle, comprising the SOH estimation apparatus according to any one of claims 1 to 6.

10. A SOH estimation method, comprising:
obtaining battery data including voltage information and charging environment information of a target battery collected during a progress period of a charging event;
estimating a first charge capacity associated with a current life state of the target battery based on the battery data using a first model;
estimating a second charge capacity associated with an initial life state of the target battery based on the battery data using a second model; and
estimating a SOH of the battery based on the first charge capacity and the second charge capacity.
